# EUROPÄISCHE PATENTSCHRIFT

(11) **EP 0 739 156 B1**
(45) Veröffentlichungstag und Bekanntmachung des Hinweises auf die Patenterteilung: **31.01.2001**
(21) Anmeldenummer: 96105551.4
(22) Anmeldetag: 04.04.1996
(51) Int. Cl.: H05K 7/14

(54) **Gekapselte Ein-/Ausgabebaugruppe**
Encapsulated input/output assembly
Ensemble d'entrée/sortie encapsulé

(30) Priorität: 21.04.1995 DE 19514767
(43) Veröffentlichungstag der Anmeldung: 23.10.1996
(73) Patentinhaber: SIEMENS AKTIENGESELLSCHAFT, 80333 München (DE)
(72) Erfinder: Schirbl, Reinhard, 92421 Schwandorf (DE); Deinhardt, Günther, Dipl.-Ing. (FH), 92224 Amberg (DE); Meiler, Werner, 92263 Ebermannsdorf (DE)

(56) Entgegenhaltungen:
- EP-A- 0 162 373
- EP-A- 0 527 247
- EP-A- 0 550 324
- EP-A- 0 592 712
- EP-A- 0 644 373
- DE-A- 3 635 971

## Beschreibung

Die vorliegende Erfindung betrifft eine gekapselte Ein- und/oder Ausgabebaugruppe der Steuerungstechnik gemäß dem Oberbegriff des Anspruchs 1.

Aus der EP 0 592 712 A1 ist eine gekapselte Baugruppe einer speicherprogrammierbaren Steuerung bekannt. Die Baugruppe weist einen an der Vorderseite der Kapselung angeordneten, im Wesentlichen U-förmigen Aufnahmekanal zur Aufnahme eines Frontsteckers auf, an dem über Anschlusselemente Prozessleitungen anschließbar sind. Ferner ist die Baugruppe mit einer Leiterplatte versehen, die sich in der Kapselung seitlich bis in den Bereich des Aufnahmekanals erstreckt.

Die Lehre aus der EP 0 527 247 A1 offenbart einen selbstaufbauenden Bus mit mehreren Baugruppen, die jeweils eine Kapsel zur Aufnahme einer Leiterplatte aufweisen.

Aus der DE OS 36 35 971 A1 ist eine Baugruppe mit einer Leiterplatte bekannt, die auf einen Baugruppenträger aufgesteckt wird. Die Leiterplatte ist in dem Bereich bestückungsfrei, in dem sie beim Aufstecken an einem Vorsprung am Baugruppenträger vorbei geführt wird.

Aus der EP 0 644 373 A1 ist eine gekapselte Ein- und/oder Ausgabebaugruppe der eingangs genannten Art bekannt.

Ausgehend von diesem Stand der Technik besteht die Aufgabe der vorliegenden Erfindung darin, die für die Aufnahme des Frontsteckers benötigte Baugruppenbreite zu minimieren bzw. umgekehrt die Breite des Aufnahmekanals bei gegebener Baugruppenbreite zu maximieren.

Diese Aufgabe wird durch die im kennzeichnenden Teil des Anspruchs 1 angegebenen Maßnahmen gelöst.

Weitere Vorteile und Einzelheiten ergeben sich aus der nachfolgenden Beschreibung eines Ausführungsbeispiels. Dabei zeigen:
- FIG 1: eine Explosionsdarstellung einer Ein-/Ausgabebaugruppe der Steuerungstechnik nebst zugehörigem Frontstecker,
- FIG 2: einen Ausschnitt einer der Leiterplatten der Baugruppe,
- FIG 3: einen Ausschnitt der Rückseite des Frontsteckers,
- FIG 4: eine mögliche Codierung,
- FIG 5: eine weitere mögliche Codierung und
- FIG 6: das Zusammenwirken der Rastvorrichtungen von Aufnahmekanal und Frontstecker.

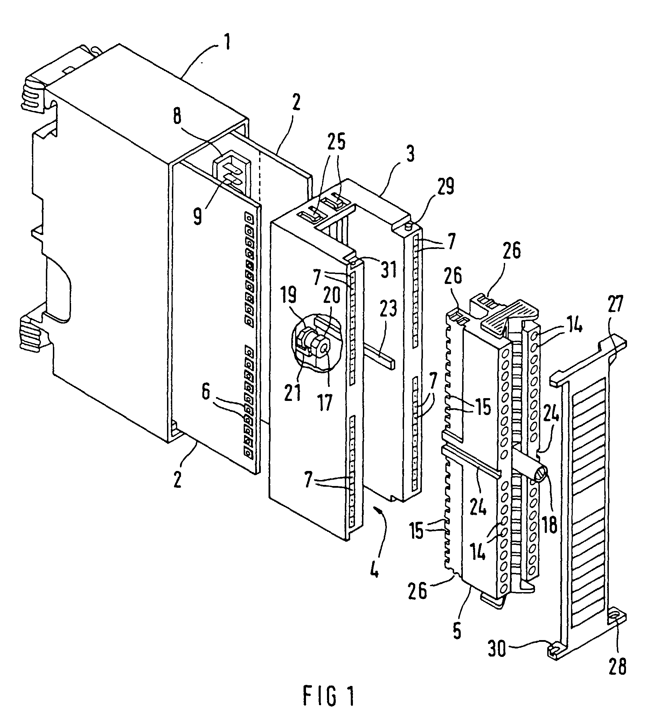

Gemäß FIG 1 besteht die Kapselung der Baugruppe aus einem Basisteil 1, auf das nach dem Einschieben der Leiterplatten 2 eine Haube 3 aufgesetzt wird, um die Kapselung zu vervollständigen.

Wie aus FIG 1 sofort ersichtlich ist, sind die Leiterplatten 2 innen an den Seiten der Kapselung angeordnet. Sie erstrekken sich dabei seitlich bis in den Bereich des U-förmigen Aufnahmekanals 4, der an der Vorderseite der Kapselung angeordnet ist. Die Leiterplatten 2 rahmen also sozusagen den Aufnahmekanal 4 auf beiden Seiten ein.

Der Aufnahmekanal 4 dient der Aufnahme des Front- bzw. Prozeßsteckers 5, an den, wie später noch näher erläutert wird, eine Vielzahl von Prozeßleitungen anschließbar ist. Um die Breite des Aufnahmekanals 4 und damit auch die Breite des Frontsteckers 5 bei gegebener Baugruppenbreite möglichst groß gestalten zu können, sind die Leiterplatten 2 im Bereich des Aufnahmekanals 4 - für die hintere der beiden Leiterplatten 2 also rechts von der gestrichelt eingezeichneten Linie - auf der Seite des Aufnahmekanals 4 unbestückt, also bestückungsfrei.

Wie aus FIG 1 ferner ersichtlich ist, weisen die Leiterplatten 2 - der Übersichtlichkeit halber ist dies nur für die vordere der beiden Leiterplatten 2 dargestellt - auf der der Kapselung zugewandten Seite (also auf der dem Aufnahmekanal 4 abgewandten Seite) SMD-Leuchtdioden 6 auf, mittels derer der Zustand der über die Prozeßleitungen übertragenen Signale angezeigt werden kann. Die Leuchtdioden 6 sind dabei zwar nahe der Vorderkante der Leiterplatten 2 angeordnet, aber dennoch von der Vorderseite der Baugruppe zurückgesetzt. Ihr Licht wird daher über die Lichtleiter 7 in bekannter Art und Weise zur Vorderseite der Baugruppe geführt. Montage und Wirkungsweise der Lichtleiter sind beispielsweise in der DE 93 14 097 U, Seite 3, Zeile 1 bis Seite 4, Zeile 31 zu entnehmen. Durch die Anordnung der Leuchtdioden 6 auf den Außenseiten der Leiterplatten 2 wird erreicht, daß die Lichtleiter 7 relativ kurz und dadurch lichtverlustarm ausgeführt sein können.

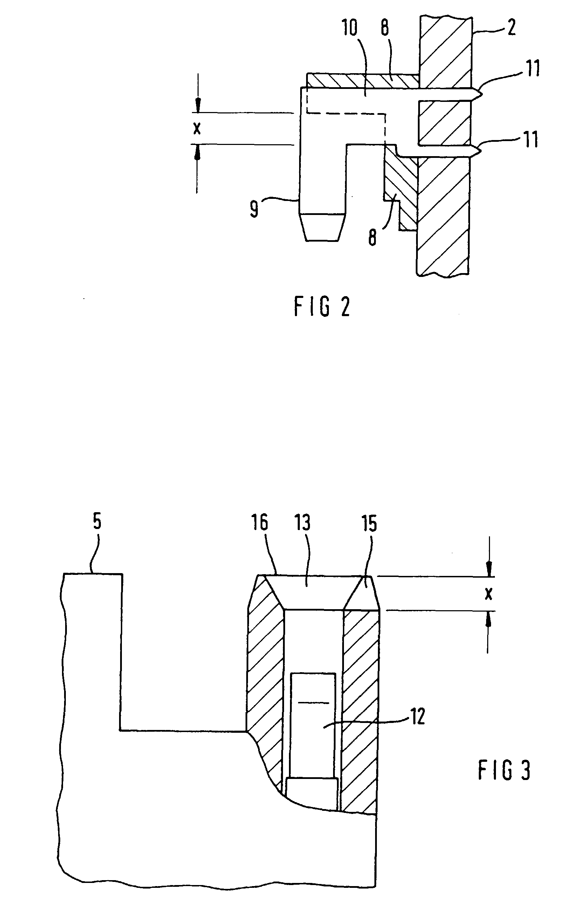

Wie aus FIG 1 in Verbindung mit FIG 2 ersichtlich ist, weisen die Leiterplatten 2 auf ihren Innenseiten - sichtbar ist nur einer bei der rechten der Leiterplatten 2 - je zwei Messerleistenblöcke 8 mit Kontaktmessern 9 auf. Die Messerleistenblöcke 8 sind aus Kunststoff hergestellte Spritzgießteile. Durch das Einbetten der Kontaktmesser 9 in die Messerleistenblöcke 8 wird die Stabilität der Kontaktmesser 9 erhöht. Die Kontaktmesser 9 sind über Verbindungsstücke 10 mit Kontaktstiften 11 verbunden, die in die Leiterplatten 2 eingepreßt sind. Wie insbesondere aus FIG 2 ersichtlich ist, stehen die Verbindungsstücke 10 über die Messerleistenblöcke 8 um das Wegstück x vor.

Beim vollständigen Einführen des Frontsteckers 5 in den Aufnahmekanal 4 kontaktieren die Kontaktmesser 9 mit in FIG 3 gezeigten korrespondierenden Gegenkontakten 12, die in Messerleistenaufnahmen 13 des Frontsteckers 5 angeordnet sind. Auch die Messerleistenaufnahmen 13 sind folglich auf beiden Seiten des Frontsteckers 5 angeordnet. Sie dienen der elektrisch leitenden Verbindung der Kontaktmesser 9 mit den korrespondierenden, ebenfalls auf beiden Seiten der Frontseite des Frontsteckers 5 angeordneten Anschlußelementen 14, hier Schraubklemmen 14.

Wie in FIG 1 angedeutet und besonders deutlich aus FIG 3 ersichtlich ist, weisen die Messerleistenaufnahmen 13 an ihren Außenseiten, d. h. an den Außenseiten des Frontsteckers 5, Ausnehmungen 15 auf, welche der Aufnahme der Verbindungsstücke 10 dienen. Die Stege der Verbindungsstücke 10, die über die Messerleistenblöcke 8 vorstehen, können daher in die Ausnehmungen 15 eintauchen. Dadurch kann der Frontstecker 5 soweit in den Aufnahmekanal eingesetzt werden, daß die Rückseite 16 des Frontsteckers 5 die Messerleistenblöcke 8 berührt. Der Frontstecker 5 kann durch diese Maßnahmen um den in den FIG 2 und 3 eingezeichneten Weg x weiter in den Aufnahmekanal 4 eingeführt werden, wobei dennoch die erforderlichen Kriech- und Luftstrecken zwischen spannungsführenden Kontakteilen des Frontsteckers 5 und seiner Außenkontur realisierbar sind.

Wie wiederum aus FIG ersichtlich ist, ist im Aufnahmekanal 4 eine Gewindebohrung 17 angeordnet, die von vorne gesehen zentral gelegen ist und die mit einer im Frontstecker 5 angeordneten, axial unverschieblich gelagerten Schraube zusammenwirkt. Durch die Umsetzung der Drehbewegung der Schraube 18 in eine Linearbewegung des Frontsteckers 5 können die Kräfte, die zum Stecken und Ziehen des Frontsteckers 5 benötigt werden, leicht aufgebracht werden.

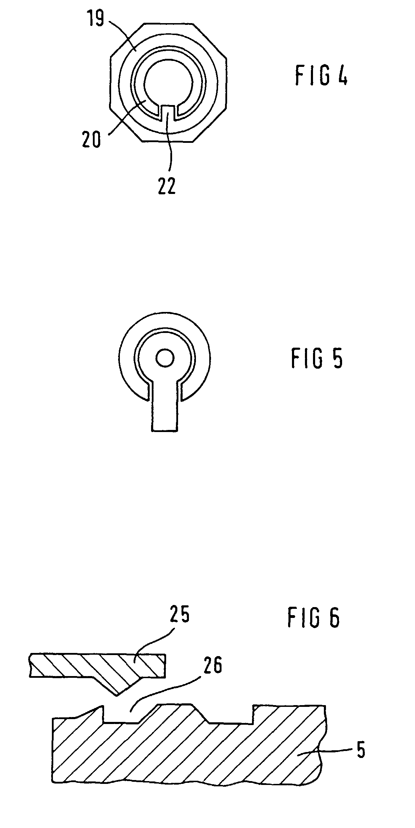

Im Aufnahmekanal 4 ist um die Gewindebohrung 17 herum ein Codierelement 19 fest angeordnet, welches mit einem Gegencodierelement 20 lösbar verbunden ist. Diese Anordnung der Codierung ist besonders platzsparend. Das Codierelement 19 ist beispielsweise mittels zweier Rasthaken 21 (dargestellt ist der Übersichtlichkeit halber nur einer der Rasthaken) im Aufnahmekanal 4 befestigt. Das Codierelement 19 ist, wie aus FIG 1 und besonders deutlich aus FIG 4 ersichtlich ist, achteckig ausgebildet, so daß es in acht verschiedenen Stellungen in den Aufnahmekanal 4 einsetzbar ist. Mit dem Codierelement 19 ist lösbar (z. B. über federnde Elemente) das Gegencodierelement 20 verbunden. Beim ersten Einsetzen des Frontsteckers 5 in den Aufnahmekanal 4 verrastet dann das Gegencodierelement 20 im Frontstecker 5, so daß dieser beim ersten Stecken codiert wird. Codierelement 19 und Gegencodierelement 20 sind also selbstcodierend ausgebildet. Das Gegencodierelement 20 verrastet im Frontstecker 5 beispielsweise in einer - der Übersichtlichkeit halber nicht dargestellten Gegencodierelementaufnahme - , die ebenfalls zwei Rasthaken aufweist.

Codierelement 19 und Gegencodierelement 20 sind - mit Ausnahme der Codierung selbst - gleich aufgebaut. Dadurch kann das aus Codierelement 19 und Gegencodierelement 20 bestehende Codierpärchen auch verkehrtherum in den Aufnahmekanal 4 eingesetzt werden. Dadurch stehen nicht nur 8, sondern 2 x 8, insgesamt also 16 Codierungen zur Verfügung.

Wie aus FIG 4 ersichtlich ist, sind Codierelement 19 und Gegencodierelement 20 nach den sogenannten Schlüssel-Schloß-Prinzip ausgebildet. Der Schlüsselbart 22 ist dabei derart angeordnet, daß er nach innen und nicht nach außen ragt. Dadurch kann nämlich die Baubreite von Codierelement 19 und Gegencodierelement 20 kleiner gehalten werden als im umgekehrten Fall, der in FIG 5 dargestellt ist.

Beim Einführen des Frontsteckers 5 in den Aufnahmekanal 4 wird der Frontstecker 5 durch zwei Führungsschienen 23 - sichtbar ist nur eine der Führungsschienen 23 -, die an den Seiten des Aufnahmekanals 4 angeordnet sind und mit korrespondierenden Führungsnuten 24 des Frontsteckers 5 zusammenwirken, geführt. Die Führungsschienen 23 sind dabei asymmetrisch ausgebildet, so daß der Frontstecker 5 nur in einer einzigen Lage in den Aufnahmekanal 4 einsetzbar ist. Alternativ oder zusätzlich könnten die Führungsschienen 23 auch asymmetrisch angeordnet sein. So kann auf einfache Weise verhindert werden, daß der Frontstecker 5 um 180° gedreht in den Aufnahmekanal 4 eingesetzt wird.

Beim Einführen des Frontsteckers 5 in den Aufnahmekanal 4 verrastet der Frontstecker 5 zunächst in einer Vorraststellung. In der Vorraststellung sind die Kontaktmesser 9 noch elektrisch von den Gegenkontakten 12 (vgl. FIG 3) getrennt. Die Vorraststellung des Frontsteckers 5 wird dadurch bewirkt, daß federnd gelagerte Rastelemente 25, die am oberen und - nicht sichtbar am unteren Ende des Aufnahmekanals 4 angeordnet sind mit Rastausnehmungen 26 des Frontsteckers 5 zusammenwirken. Wie besonders deutlich aus FIG 6 erkennbar sind sowohl die Rastelemente 25 als auch die Rastausnehmungen 26 angeschrägt. Dadurch kann der Frontstecker 5 nur durch Kraftanwendung, also ohne Betätigen eines wie auch immer gearteten Löseelements, aus der Vorraststellung gelöst werden.

Die axial unverschieblich gelagerte Schraube 18, die Gewindebohrung 17, die Rastelemente 25 und die Rastausnehmungen 26 sind dabei derart dimensioniert, daß das vordere Ende der Schraube 18, also der Schraubenanfang, in der Vorraststellung gerade in die Gewindebohrung 17 hineinragt. Dadurch kann der Frontstecker 5 nur durch Betätigen der Schraube 18 in den Aufnahmekanal 4 und damit in seine Endstellung hineingezogen werden.

Ergänzend sei noch erwähnt, daß die Bauhöhe der Codierelemente 19,20 derart bemessen ist, daß sie das Einführen des Frontsteckers 5 in den Aufnahmekanal 4 vor Erreichen der Vorraststellung beendet. Eine Zerstörung der Codierung durch das Drehmoment, das über die Schraube 18 in eine Axialbewegung umgesetzt wird, kann daher nicht erfolgen.

Wie schließlich noch aus FIG 1 ersichtlich ist, kann eine als Beschriftungsblende ausgebildete Frontabdeckung 27 an ihren Ausnehmungen 28 in korrespondierende Vorsprünge 29 eingehängt werden. Die Frontabdeckung ist dann um diese Vorsprünge 29 schwenkbar. Sie rastet in der Endstellung mit ihren Ausnehmungen 30 in Vorsprünge 31 ein, so daß sie in der Endstellung den Aufnahmekanal abdeckt.

Vorstehend beschriebene Erfindung ist selbstverständlich vielseitig anwendbar. Besonders bietet sich aber die Anwendung in einer Ein- und/oder Ausgabebaugruppe einer modular aufgebauten speicherprogrammierbaren Steuerung an.

## Patentansprüche

1. Gekapselte Ein- und/oder Ausgabebaugruppe der Steuerungstechnik,
- mit einer aus einem Basisteil (1) und einer Haube (3) bestehenden Kapselung, wobei die Haube (3) einen im wesentlichen U-förmigen Aufnahmekanal (4) zur Aufnahme eines Frontsteckers (5)aufweist, an den über Anschlußelemente (14) Prozeßleitungen anschließbar sind,
- mit mindestens einer innerhalb der Kapselung an einer Seite angeordneten Leiterplatte (2), die sich bis in die Haube (3) erstreckt,
- mit an der Leiterplatte (2) von der Vorderseite der Baugruppe zurückgesetzt angeordneten Leuchtdioden (6), die ihr Licht über Lichtleiter (7) zur Vorderseite führen,
**dadurch gekennzeichnet,**
- dass die Leuchtdioden (6) auf der dem Aufnahmekanal (4) abgewandten Seite der Leiterplatte (2) angeordnet sind, und
- dass die Leiterplatte (2) auf der Seite des Aufnahmekanals (4) unbestückt ist.

2. Baugruppe nach Anspruch 1, dadurch gekennzeichnet, dass die Baugruppe zwei Leiterplatten (2) aufweist, die sich bis in die Haube (3) erstrecken und den Aufnahmekanal (4) auf beiden Seiten einrahmen, wobei
- die Leuchtdioden (6) jeder Leiterplatte (2) auf der dem Aufnahmekanal (4) abgewandten Seite der Leiterplatte (2) angeordnet sind, und
- jede Leiterplatte (2) auf der Seite des Aufnahmekanals (4) unbestückt ist.

3. Baugruppe nach Anspruch 1 oder 2, **dadurch gekennzeichnet,** daß auf den nach innen gewandten Seiten der Leiterplatten (2) Messerleistenblöcke (8) mit Kontaktmessern (9) angeordnet sind, die mit korrespondierenden Messerleistenaufnahmen (13) des Frontsteckers (5) zusammenwirken.

4. Baugruppe nach Anspruch 3, **dadurch gekennzeichnet,** daß die Kontaktmesser (9) über Verbindungsstücke (10) mit in die Leiterplatten (2) eingefügten Kontaktstiften (11) verbunden sind, daß die Verbindungsstücke (10) über die Messerleistenblöcke (8) vorstehen und daß die Messerleistenaufnahmen (13) an ihren Außenseiten mit den Verbindungsstücken (10) korrespondierende Ausnehmungen (15) aufweisen, so daß der Frontstecker (5) soweit in den Aufnahmekanal (4) einsetzbar ist, daß die Messerleistenaufnahmen (13) die Messerleistenblöcke (8) berühren.

5. Baugruppe nach Anspruch 3 oder 4, **dadurch gekennzeichnet,** daß die Kontaktstifte (11) in die Leiterplatten (2) eingepreßt sind.

6. Baugruppe nach einem der Ansprüche 2 bis 5, **dadurch gekennzeichnet**, daß der Aufnahmekanal (4) eine von vorne gesehen zentral angeordnete Gewindebohrung (17) aufweist, die mit einer im Frontstecker (5) angeordneten, axial unverschieblich gelagerten Schraube (18) zusammenwirkt, und daß die Anschlußelemente (14) und die Messerleistenaufnahmen (13) jeweils auf beiden Seiten der Front- bzw. Rückseite (16) des Frontsteckers (5) angeordnet sind.

7. Baugruppe nach Anspruch 6, **dadurch gekennzeichnet,** daß am Aufnahmekanal (4) um die Gewindebohrung (17) herum ein Codierelement (19) angeordnet ist, das mit einem im Frontstecker (5) um die Schraube (18) herum angeordneten Gegencodierelement (20) zusammenwirkt.

8. Baugruppe nach Anspruch 7, **dadurch gekennzeichnet,** daß das Codierelement (19) und das Gegencodierelement (20) selbstcodierend ausgebildet sind.

9. Baugruppe nach Anspruch 7 oder 8, **dadurch gekennzeichnet,** daß das Codierelement (19) und das Gegencodierelement (20) nach dem Schlüssel-Schloß-Prinzip ausgebildet sind, wobei der Schlüsselbart (22) nach innen ragt.

10. Baugruppe nach einem der Ansprüche 1 bis 9, **dadurch gekennzeichnet,** daß der Aufnahmekanal (4) an seinem oberen und seinem unteren Ende federnd gelagerte Rastelemente (25) aufweist, die mit Rastausnehmungen (26) des Frontsteckers (5) in einer Vorraststellung zusammenwirken.

11. Baugruppe nach Anspruch 10, **dadurch gekennzeichnet,** daß die Rastelemente (25) und/oder die Rastausnehmungen (26) derart angeschrägt sind, daß der Frontstecker (5) ohne Betätigen eines Löseelements aus der Vorraststellung lösbar ist.

12. Baugruppe nach einem der Ansprüche 6 bis 9 und einem der Ansprüche 10 oder 11, **dadurch gekennzeichnet,** daß die Schraube (18), die Gewindebohrung (17), die Rastelemente (25) und die Rastausnehmungen (26) derart dimensioniert sind, daß der Schraubenanfang in der Vorraststellung gerade in die Gewindebohrung (17) hineinragt, so daß der Frontstecker (5) durch Betätigen der Schraube (18) in den Aufnahmekanal (4) hineingezogen wird.

13. Baugruppe nach einem der Ansprüche 1 bis 12, **dadurch gekennzeichnet,** daß der Aufnahmekanal (4) auf jeder Seite mindestens eine Führungsschiene (23) aufweist, die mit Führungsnuten (24) des Frontstekkers (5) zusammenwirken.

14. Baugruppe nach Anspruch 13, **dadurch gekennzeichnet,** daß die Führungsschienen (23) asymmetrisch ausgebildet und/oder angeordnet sind, so daß der Frontstecker (5) nur in einer einzigen Lage in den Aufnahmekanal (4) einsetzbar ist.

15. Baugruppe nach einem der Ansprüche 1 bis 14, **dadurch gekennzeichnet,** daß der Aufnahmekanal (4) durch eine Frontabdeckung (27) abdeckbar ist.

16. Baugruppe nach Anspruch 15, **dadurch gekennzeichnet,** daß die Frontabdeckung (27) als Beschriftungsblende ausgebildet ist.

## Claims

1. Enclosed control-technology input and/or output module
- having an enclosure comprising a base portion (1) and a cover (3), the cover (3) having a substantially U-shaped receiving channel (4) for receiving a front-panel connector (5), to which process lines can be connected by way of connection elements (14),
- having at least one printed-circuit board (2) arranged inside the enclosure on one side, which printed-circuit board extends until in the cover (3),
- having light-emitting diodes (6) arranged on the printed-circuit board (2) in a manner such that they are set back from the front side of the module, which light-emitting diodes send their light to the front side by way of light guides (7),
characterised
- in that the light-emitting diodes (6) are arranged on the side of the printed-circuit board (1) that faces away from the receiving channel (4), and
- in that the printed-circuit board (2) is bare on the side of the receiving channel.

2. Module according to claim 1, characterised in that the module has two printed-circuit boards (2) which extend until in the cover (3) and frame the receiving channel (4) on both sides, wherein
- the light-emitting diodes (6) of each printed-circuit board (2) are arranged on the side of the printed-circuit board (2) that faces away from the receiving channel (4), and
- each printed-circuit board (2) is bare on the side of the receiving channel (4).

3. Module according to claim 1 or 2, characterised in that arranged on the inward-facing sides of the printed-circuit boards (2) are male multipoint connector blocks (8) having contact blades (9), which cooperate with corresponding male multipoint connector receivers (13) of the front-panel connector (5).

4. Module according to claim 3, characterised in that the contact blades (9) are connected by way of connection pieces (10) to contact pins (11) inserted into the printed-circuit boards (2), in that the connection pieces (10) protrude over the male multipoint connector blocks (8), and in that the male multipoint connector blocks (13) have, on their outer sides, recesses (15) corresponding to the connection pieces (10), so that the front-panel connector (5) can be inserted so far into the receiving channel (4) that the male multipoint connector receivers (13) contact the male multipoint connector blocks (8).

5. Module according to claim 3 or 4, characterised in that the contact pins (11) are pressed into the printed-circuit boards (2).

6. Module according to one of claims 2 to 5, characterised in that the receiving channel (4) has a threaded bore (17), which is arranged centrally when viewed from the front and cooperates with a screw (18), which is arranged in the front-panel connector (5) and mounted axially undisplaceably, and in that the connection elements (14) and the male multipoint connector receivers (13) are arranged in each case on both sides of the front side and rear side (16), respectively, of the front-panel connector (5).

7. Module according to claim 6, characterised in that arranged on the receiving channel (4), around the threaded bore (17), is a coding element (19), which cooperates with a counter-coding element (20) arranged in the front-panel connector (5), around the screw (18).

8. Module according to claim 7, characterised in that the coding element (19) and the counter-coding element (20) are constructed in a manner such that they are self-coding.

9. Module according to claim 7 or 8, characterised in that the coding element (19) and the counter-coding element (20) are constructed according to the key-lock principle, the key bit (22) projecting inwards.

10. Module according to one of claims 1 to 9, characterised in that on its upper end and on its lower end, the receiving channel (4) has spring-mounted locking elements (25), which cooperate with locking recesses (26) of the front-panel connector (5) in a pre-locking position.

11. Module according to claim 10, characterised in that the locking elements (25) and/or the locking recesses (26) are bevelled in such a way that the front-panel connector (5) can be released from the pre-locking position without actuating a release element.

12. Module according to one of claims 6 to 9 and one of claims 10 or 11, characterised in that the screw (18), the threaded bore (17), the locking elements (25) and the locking recesses (26) are dimensioned in such a way that in the pre-locking position, the start of the screw projects straight into the threaded bore (17), so that the front-panel connector (5) can be pulled into the receiving channel (4) by actuating the screw (18).

13. Module according to one of claims 1 to 12, characterised in that the receiving channel (4) has on each side at least one guide rail (23), which guide rails cooperate with guide grooves (24) of the front-panel connector (5).

14. Module according to claim 13, characterised in that the guide rails (23) are constructed and/or arranged asymmetrically, so that the front-panel connector (5) can be inserted into the receiving channel (4) only in one single position.

15. Module according to one of claims 1 to 14, characterised in that the receiving channel (4) can be covered by a front cover (27).

16. Module according to claim 15, characterised in that the front cover (27) is constructed as a labelling screen.

## Revendications

1. Module d'entrée/sortie encapsulé de la technique de commande,
- comportant un encapsulage constitué d'une partie (1) de base et d'une coiffe (3), la coiffe (3) comportant un canal (4) de réception sensiblement en forme de U pour la réception d'un connecteur (5) frontal auquel des conducteurs de commande de processus peuvent être raccordés par l'intermédiaire d'éléments (14) de raccordement,
- comportant au moins une plaquette (2) à circuit imprimé qui est montée à l'intérieur de l'encapsulage, sur une face, et qui s'étend dans la coiffe (3),
- comportant des diodes (6) luminescentes qui sont montées sur la plaquette (2) à circuit imprimé en retrait de la face avant du module et qui guident leur lumière vers la face avant par l'intermédiaire de guides (7) lumineux,
caractérisé en ce que
- les diodes (6) luminescentes sont montées sur la face de la plaquette (2) à circuit imprimé tournée vers le canal (4) de réception et en ce que
- la plaquette (2) à circuit imprimé est exempte de garnissage du côté du canal (4) de réception.

2. Module suivant la revendication 1, caractérisé en ce que le module comporte deux plaquettes (2) à circuit imprimé qui s'étendent jusqu'à la coiffe (3) et qui encadrent le canal (4) de réception des deux côtés,
- les diodes (6) luminescentes de chaque plaquette (2) à circuit imprimé étant montées sur la face de la plaquette (2) à circuit imprimé tournée vers le canal (4) de réception, et
- chaque plaquette (2) à circuit imprimé étant exempte de garnissage du côté du canal (4) de réception.

3. Module suivant la revendication 1 ou 2, caractérisé en ce qu'il est monté sur les faces tournées vers l'intérieur des plaquettes (2) à circuit imprimé des blocs (8) de réglettes de contact à couteaux comportant des couteaux (9) de contact qui coopèrent avec des dispositifs (13) de réception de réglettes de contact à couteaux correspondantes du connecteur (5) frontal.

4. Module suivant la revendication 3, caractérisé en ce que les couteaux (9) de contact sont reliés par l'intermédiaire de pièces (10) de liaison à des broches (11) de contact insérées dans les plaquettes (2) à circuit imprimé, en ce que les pièces (10) de contact font saillie des blocs (8) de réglettes de contact à couteaux et en ce que les dispositifs (13) de réception de réglettes de contact à couteaux comportent sur leur face extérieure comportant les pièces (10) de liaison des évidements (15) correspondants, si bien que le connecteur (5) frontal peut être introduit dans le canal (4) de réception jusqu'à ce que les dispositifs (13) de réception de réglettes de contact à couteaux poussent les blocs (8) de réglettes de contact à couteaux.

5. Module suivant la revendication 3 ou 4, caractérisé en ce que les broches (11) de contact sont enfoncées dans les plaquettes (2) à circuit imprimé.

6. Module suivant l'une des revendications 2 à 5, caractérisé en ce que le canal (4) de réception comporte un trou (17) taraudé monté, vu de l'avant, de manière centrale, qui coopère avec une vis (18) disposée dans le connecteur (5) frontal et montée axialement sans possibilité de coulissement, et en ce que les éléments (14) de raccordement et les dispositifs (13) de réglettes de contact à couteaux sont disposés chaque fois des deux côtés de la face avant ou de la face (16) arrière du connecteur (5) frontal.

7. Module suivant la revendication 6, caractérisé en ce qu'il est monté sur le canal (4) de réception, autour du trou (17) taraudé, un élément (19) de codage qui coopère avec un élément (20) de codage antagoniste monté dans le connecteur (5) frontal, autour de la vis (18).

8. Module suivant la revendication 7, caractérisé en ce que l'élément (19) de codage et l'élément (20) de codage antagoniste sont réalisés en étant codés de manière autonome.

9. Module suivant la revendication 7 ou 8, caractérisé en ce que l'élément (19) de codage et l'élément (20) de codage antagoniste sont réalisés suivant le principe clé-serrure, le panneton (22) faisant saillie vers l'intérieur.

10. Module suivant l'une des revendications 1 à 9, caractérisé en ce que le canal (4) de réception comporte à son extrémité supérieure et à son extrémité inférieure des éléments (25) d'encliquetage qui sont montés de manière élastique et qui coopèrent avec des évidements (26) d'encliquetage du connecteur (5) frontal en une position de préencliquetage.

11. Module suivant la revendication 10, caractérisé en ce que les éléments (25) d'encliquetage et/ou les évidements (26) d'encliquetage sont biseautés de telle manière que le connecteur (5) frontal peut être détaché de la position de préencliquetage sans actionnement d'un élément de détachement.

12. Module suivant l'une des revendications 6 à 9 et l'une des revendications 10 ou 11, caractérisé en ce que la vis (18), le trou (17) taraudé, les éléments (25) d'encliquetage et les évidements (26) d'encliquetage sont dimensionnés de telle manière que le début de la vis rentre en la position de préencliquetage juste dans le trou (17) taraudé, si bien que le connecteur (5) frontal est enfoncé dans le canal (4) de réception en actionnant la vis (18).

13. Module suivant l'une des revendications 1 à 12, caractérisé en ce que le canal (4) de réception comporte sur chaque face au moins un rail (23) de guidage qui coopère avec des rainures (24) de guidage du connecteur (5) frontal.

14. Module suivant la revendication 13, caractérisé en ce que les rails (23) de guidage sont réalisés de manière dissymétrique et/ou disposés de manière asymétrique, si bien que le connecteur (5) frontal ne peut être introduit qu'en une seule position dans le canal (4) de réception.

15. Module suivant l'une des revendications 1 à 14, caractérisé en ce que le canal (4) de réception peut être recouvert d'un revêtement (27) frontal.

16. Module suivant la revendication 15, caractérisé en ce que le revêtement (27) frontal est réalisé en plaques d'inscription.
